# EUROPÄISCHE PATENTSCHRIFT

(11) **EP 4 354 093 B1**
(45) Veröffentlichungstag und Bekanntmachung des Hinweises auf die Patenterteilung: **21.05.2025**
(21) Anmeldenummer: 23196671.4
(22) Anmeldetag: 11.09.2023
(51) Int. Cl.: G01D 11/30, G01S 7/00, H03K 17/945, H03K 17/95

(54) **BEFESTIGUNGSVORRICHTUNG FÜR EINEN SENSOR UND EINE SENSOREINHEIT**
FASTENING DEVICE FOR A SENSOR AND A SENSOR UNIT
DISPOSITIF DE FIXATION POUR UN CAPTEUR ET UNITÉ DE DÉTECTION

(30) Priorität: 12.10.2022 DE 102022126588
(43) Veröffentlichungstag der Anmeldung: 17.04.2024
(73) Patentinhaber: Turck Holding GmbH, 58553 Halver (DE)
(72) Erfinder: Makkinga, Alexander Magnus, 45481 Mülheim an der Ruhr (DE)
(74) Vertreter: DTS Patent- und Rechtsanwälte PartmbB

(56) Entgegenhaltungen:
- EP-A1- 0 737 847
- DE-A1- 102017 103 512
- DE-U1- 20 019 722
- DE-U1- 20 301 144
- DE-U1- 202015 104 895

## Beschreibung

Die vorliegende Erfindung betrifft ein Lagerungselement für ein elektronisches Endgerät nach Anspruch 1 und ein elektronisches Endgerät nach Anspruch 12.

Dem Stand der Technik sind Halterungen für Sensoren oder sonstige endständige Geräte bekannt, die eine feste Orientierung des Sensors zur Halterung vorgeben oder verstellbar konstruiert sind.

Dabei ist wichtiges Merkmal solcher Sensoren und Endgeräte, dass sich die Position der aktiven Fläche, wie die Erfassungsseite, an die aktuellen Gegebenheiten im Feld anpassen lässt.

Beispielsweise offenbart die WO 2004/477246 A1 eine Halterung in Form eines Gehäuses zur Aufnahme eines elektrischen Sensors, der weiterhin eine Anzeigevorrichtung zur Anzeige verschiedener elektrischer Zustände aus unterschiedlichen Blickrichtungen aufweist. Bei diesem Gehäuse ist der Sensor in seiner Orientierung zum Gehäuse festgelegt, so dass das gesamte Gehäuse in der Orientierung verändert werden muss, wenn der Sensor eine Neuausrichtung erfahren soll.

Die DE 10147023 A1 schlägt hierzu eine Verbesserung vor, indem eine Befestigungsvorrichtung für Sensoren mit einem Gehäuse zur Aufnahme des Sensors ausgestattet ist, wobei eine separate Montageplatte zur Befestigung an einen Untergrund vorgesehen ist, so dass zwischen dem Gehäuse und der Montageplatte Befestigungsmittel zur lösbaren Befestigung des Gehäuses auf der Montageplatte vorgesehen sind. Hierdurch sind die Befestigungsmittel derart ausgebildet, dass die Ausrichtung des Gehäuses gegenüber der Montageplatte verstellbar ist. Die DE 10147023 A1 offenbart weiterhin, dass die Ausrichtung des Gehäuses gegenüber der Montageplatte stufenweise um jeweils 90° verstellbar sein kann.

Dieses Befestigungselement ist dem Grunde nach gut geeignet, unterschiedliche Ausrichtungen für ein elektronisches Endgerät zu ermöglichen, wobei eine leichtere Handhabung des Befestigungselementes und/oder des elektronischen Endgerätes nach wie vor wünschenswert wäre.

Aus der DE 10 2017 103512 A1 ist eine Halterung für einen zylindrischen Näherungsschalter bekannt.

Es ist die Aufgabe der vorliegenden Erfindung ein verbessertes Befestigungselement und ein verbessertes elektronisches Endgerät vorzuschlagen.

Diese Aufgabe wird erfindungsgemäß gelöst durch ein Lagerungselement nach den Merkmalen des Anspruchs 1 und einem elektronischen Endgerät mit einem solchen Lagerungselement nach den Merkmalen des Anspruches 12. Vorteilhafte Ausgestaltungen sind in den jeweiligen, zugehörigen Unteransprüchen angegeben. Demnach wird die Aufgabe gelöst durch eine Lagerungseinheit für ein elektronisches Endgerät gemäß Anspruch 1.

Dabei kann die Auflagefläche insbesondere als ebene Fläche ausgebildet sein. Ferner kann die mindestens eine Anlagefläche als ebene Fläche ausgebildet sein. Dabei kann insbesondere die Drehachse, um die das Endgerät drehbar auf der Auflagefläche gelagert ist, senkrecht zur Auflagefläche verlaufen.

Vorliegend soll unter einem elektronischen Endgerät jedes endständige Gerät eines Automatisierungsnetzwerkes verstanden werden, das nachfolgend auch kurz nur Endgerät genannt wird. Endgeräte sind insbesondere Sensoren, Aktoren und/oder eine Empfangseinheit für Daten, wie beispielsweise ein NFC-Empfangsgerät, RFID-(Schreib-)Lesekopf oder ein IR-Datenempfänger. Es kann aber auch ein sonstiger Emitter sein, der bspw. einen Lichtstrahl, eine Schallwelle oder sonst ein sonstiges Signal versendet. Die Endgeräte weisen insbesondere eine zur Auflagefläche der Lagerungseinheit komplementäre Fußfläche auf, die auf der Auflagefläche der Lagerungseinheit auf- oder anliegt. Die Auflagefläche der Lagerungseinheit und/oder die Fußfläche des elektronischen Endgerätes sind vorteilhafterweise ein- oder mehrteilig aufgebaut. Weiterhin kann eine Verbesserung darin besehen, dass Rastmittel auf der Fußfläche und/oder der Auflagefläche vorgesehen sind, womit eine definierte Drehposition sicher eingestellt werden kann.

Der Neigungswinkel, den die Auflagefläche gegenüber einer äußeren Anlagefläche aufweist, korreliert mit der gewünschten Ausrichtung und Anzahl an Ausrichtungen des elektronischen Endgerätes und ist nicht eingeschränkt. Bei den üblichen vertikalen Tragelementen ist es vorteilhaft, wenn der Neigungswinkel 45° oder einen ganzzahligen Bruchteil hiervon beträgt, wie bspw. 45°/2 oder 45°/3, so dass in einer Drehwinkelstellung eine zu 90° veränderte Ausrichtung des elektronischen Endgerätes erreichbar ist.

Anders ausgedrückt, bildet die Auflagefläche mit der Anschlussseite und einer Anlagefläche der Lagerungseinheit in der Seiten- oder einer Schnittansicht ein Dreieck, wobei der Neigungswinkel der Anschlussseite gegenüber liegt.

Die Lagerungseinheit und das elektronische Endgerät ist grundsätzlich, an jeder Art von Tragelement vorgesehen, so dass Tragelement nicht einschränkend zu verstehen ist und insbesondere eine Wand, ein Träger, eine Stütze, ein Haltearm und/oder ein sonstiges, tragendes und/oder stützendes Bauteil sein kann.

Unter einem Befestigungselement soll vorliegend insbesondere jedes Element verstanden werden, welches ein Befestigungsmittel, wie bspw. eine Schraube aufnehmen, führen und/oder halten kann. Ein Befestigungselement ist vorliegend insbesondere eine Öse, eine Bohrung und/oder ein Muttergewinde, insbesondere eine beidseitig offene Öse, Bohrung und/oder Muttergewinde.

Eine Anlageseite wird insbesondere dadurch charakterisiert, dass durch das Zusammenwirken des Befestigungselements mit einem zugehörigen Befestigungsmittel, die Anlageseite an einem Tragelement angelegt und unter Krafteinwirkung angedrückt werden kann.

Vorteilhafterweise ist das mindestens eine verschwenkbare Riegelelement an der Lagerungseinheit derart gelagert und verschwenkbar, dass es in einer Verriegelungsposition ein Verdrehen des elektronischen Endgerätes um die Drehachse verhindert und in einer Entriegelungsposition ein Verdrehen des elektronischen Endgerätes zulässt.

Bei einer verbesserten Ausführungsform kann vorgesehen werden, dass das Riegelelement, auf der in der Verriegelungsposition dem Endgerät gegenüberliegenden Seite eine kraft- und/oder formschlüssige Rast- und/oder Führungsgeometrie aufweist und/oder ein Dämpfelement, insbesondere ein elastisches Dämpfungselement vorgesehen ist.

Diese Rast- und/oder Führungsgeometrie kann beispielsweise in einer Nut-FederAnordnung, einer Haken-Ösen-Anordnung oder vergleichbaren Anordnungen bestehen. Alternativ können am Riegelelement vorstehende Reib- oder Klemmelemente vorgesehen sein, die kraftschlüssig seitlich an das Gehäuse des Endgerätes in der Verriegelungsposition anlegbar sind.

Auf diese Weise können Vibrationen vermindert werden und ein zufälliges Verdrehen des Endgerätes bei einer nicht vollständig in die Entriegelungsposition geschwenkten Riegelelement verhindert werden.

Bei einer verbesserten Ausführungsform kann vorgesehen werden, dass das Riegelelement um eine Schwenkachse verschwenkbar ist, die parallel zu Auflagefläche und mindestens einer Anlagefläche ausgerichtet ist.

Vorteilhafterweise ist die Schwenkachse des Riegelelementes zur Auflagefläche und zu zwei Anlageflächen parallel ausgerichtet.

Um eine manipulationssichere Verriegelungsposition vorzusehen, kann ein besonderer Vorteil darin bestehen, dass bei einer weiter verbesserten Ausführungsform vorgesehen wird, dass das Riegelelement ein Befestigungselement umfasst.

Insbesondere kann es vorteilhaft sein, wenn das Befestigungselement eine Durchgangsbohrung, Durchgangsmutter, Muttergewindeabschnitt oder Durchgangsöse ist. Auf diese Weise erfolgt bei der Befestigung der Lagerungseinheit auf oder an einem Tragelement, auch für das Endgerät eine finale, dauerhafte Festlegung relativ zu der Lagerungseinheit. Um das Endgerät in seiner Drehlage zu verändern, muss die gesamte Lagerungseinheit gelöst und das Riegelelement verschwenkt werden, so dass zufällige Veränderungen vollständig oder weitgehend sicher unterbunden werden können. Hierbei kann ein Vorteil darin bestehen, wenn auf einer Teilstrecke der Durchgangsbohrung eine Durchgangsmutter oder eine Muttergewindeabschnitt vorgesehen ist.

Für einen besonders vielseitigen Einsatz kann bei einer Ausführungsform vorgesehen werden, dass das Riegelelement mit mindestens zwei Befestigungselemente ausgestatten ist, wobei mindestens zwei Befestigungselemente senkrecht oder quer zueinander ausgerichtet sind.

Hierbei meint senkrecht oder quer zueinander, dass die Längs- oder Vortriebsachsen für die Befestigungsmittel, wie für zwei zu verwendende Schrauben, zueinander senkrecht bzw. quer sind.

Eine weiterer Verbesserung kann darin bestehen, dass mindestens ein Befestigungselement eine Durchgangsbohrung oder eine Öse ist. Idealerweise ist hierbei ein Befestigungselement parallel zur Schwenkachse des Riegelelementes ausgerichtet.

Vorteilhafterweise kann vorgesehen werden, mindestens eine der als Durchgangsbohrung ausgeführten Befestigungselemente in einer Endposition des Riegelelementes mit einer gemeinsamen (Bohr-)Achse vorzusehen, welche durch das Riegelelement und das Befestigungselement geführt ist.

Anders ausgedrückt ist mindestens ein Befestigungselement als Durchgangsbohrung und/oder Öse derart geführt, dass in der Verriegelungsposition, die auch die Befestigungsposition ist, eine Teillänge der Durchgangsbohrung oder der Öse im Riegelelement angeordnet ist und senkrecht oder quer zur Drehachse geführt ist und eine Teillänge der Durchgangsbohrung oder eine weitere Öse im Lagerungskörper geführt ist.

Auf diese Weise wird das Riegelelement durch ein in der Durchgangsbohrung und/oder der Öse geführtes Befestigungsmittel seiner selbst sicher verschlossen und in der Lage festgelegt.

Bei einer hierzu alternativen Ausführungsform kann vorgesehen sein, dass der Lagerungskörper in der Flucht der Durchgangsbohrung, eines in der Verriegelungsposition befindlichen Riegelelementes, eine Aussparung aufweist. Diese Aussparung ist derart, dass diese von einem Befestigungsmittel, wie einer Schraube, überbrückt wird, um in einem komplementären Gegenbefestigungselement, wie einem Muttergewinde, im oder am Tragelement befestigt werden zu können.

Bei einer weiter verbesserten Ausführungsform kann vorgesehen werden, dass das Befestigungselement mindestens einen Lagerabschnitt aufweist, an dem das elektronische Endgerät rotierbar gelagert ist, insbesondere mittels eines komplementären Gegenlagerabschnitt rotierbar gelagert ist.

Ein solcher Lagerabschnitt und/oder ein Gegenlager können vorteilhafterweise als ein- oder zweiseitige Gleitlager ausgebildet sein. Dabei kann eine Verbesserung darin bestehen, dass der Lagerabschnitt und/oder das Gegenlager einen fingerartigen Bolzen oder Zapfen aufweist, der an seinem freien Ende Haken oder Klipse aufweist, die in dem jeweiligen Gegenelement kraft- und oder formschlüssig derart festgelegt sind, dass diese gegen Herausfallen in Richtung der Drehachse gesichert sind.

Bei einer weiter verbesserten Ausführungsform kann vorgesehen werden, das Riegelelement aus mindestens zwei Teilelementen besteht zu lassen, wobei die Teilelemente um dieselbe Schwenkachse oder jeweils um eine von zwei zueinander parallelen Schwenkachsen verschwenkbar sind.

Hierbei kann eine Verbesserung darin bestehen, dass die mindestens zwei Teilelemente des Riegelelements an den freien Enden eine Kontur aufweisen, die in der Verriegelungsposition kraft- und/oder formschlüssig ineinandergreifen. Die mindestens zwei Teilelemente des Riegelelementes sind hierbei vorteilhafterweise an zwei Schwenkachsen schwenkbar gelagert, die zueinander parallel ausgerichtet sind.

Bei einer weiter verbesserten Ausführungsform kann vorgesehen werden, dass das Riegelelement eine Durchführungsöffnung aufweist. Diese Durchführungsöffnung dient insbesondere zur Durchführung eines Steckers oder eines Steckverbinders und/oder eines Kabels, wie ein zwei oder mehradriges Kabel zur Stromversorgung und/oder Datenübermittlung für das Endgerät.

Ergänzend können hierüber auch beispielsweise in der Lagerungseinheit angeordnete Anzeigen, wie bspw. eine LED, mit Strom versorgt werden.

Diese Ausführungsform kann weiter verbessert werden, indem das ein oder mehrteilige Riegelelement auf der zur Auflagefläche zugewandten Seite eine Aussparung zur form- und/oder kraftschlüssigen Aufnahme mindestens einer Teilkontur eines Steckverbinders aufweist.

Insbesondere ist die Aussparung derart, dass ein Flansch- oder Kopfbereich eines Steckers oder eines Steckverbinders mindestens mit einem Teilabschnitt und/oder einem Teilumfang in der Verriegelungsposition des Riegelelementes klemmend gehalten wird. Hierbei kann eine Verbesserung darin bestehen, dass auf der inneren Oberfläche der Aussparung eine Klemmauflage vorgesehen ist, die den Flansch- oder Kopfbereich eines Steckers oder eines Steckverbinders mindestens mit einem Teilabschnitt und/oder einem Teilumfang in der Verriegelungsposition einklemmt.

Es kann ein weiterer Bedarf bestehen, die unbeabsichtigte Veränderung der Drehlage des Endgerätes zusätzlich zu verhindern und/oder beim Transport und bei der Lagerung des Endgerätes gemeinsam mit der Lagerungseinheit eine sichere Verbindung herzustellen. Daher kann bei einer weiter verbesserten Ausführungsform vorgesehen werden, dass das Riegelelement um eine Schwenkachse verschwenkbar und quer zur Schwenkachse heb- und absenkbar ist.

Bei einem an einem Tragelement befestigten Endgerät stellt dieses Anheben quer zur Schwenkachse einen vorlaufenden Entriegelungsschritt dar. In einem ersten Schritt muss beispielsweise das Befestigungsmittel gelöst und entfernt werden. Bevor die eigentliche Entriegelung durch das Verschwenken des Riegelelements von der Verriegelungsposition in die Entriegelungsposition vorgenommen werden kann, muss bei dieser Ausführungsform das Riegelelement in der Verriegelungsposition quer zur Schwenkachse angehoben werden, bevor es möglich ist, das Riegelelement in die Entriegelungsposition zu verschwenken.

Hierzu weist das Riegelelement beispielsweise im Bereich der Schwenkachse ein oder mehrere Langlöcher auf, in denen die Schwenkachse gelagert ist und deren Außenkontur in eine komplementäre Öffnung oder Aussparung des Lagerungskörpers aufgenommen werden kann.

Von der Erfindung ist weiterhin ein elektrisches Endgerät gemäß Anspruch 12 umfasst.

Das Endgerät ist vorteilhafterweise quaderförmig und insbesondere würfelförmig oder weitestgehend würfelförmig dimensioniert.

Bei einer vorteilhaften Ausführungsform kann vorgesehen sein, dass das Endgerät eine Fußfläche aufweist, die gleich oder im Wesentlichen dimensioniert ist, wie die Auflagefläche der Lagereinheit.

Bei einer weiteren vorteilhaften Ausführungsform ist das Endgerät ein Sensor, ein Aktor und/oder ein Datenerfassungsgerät.

Wie vorstehend schon ausgeführt, soll unter einem elektronischen Endgerät jedes endständige Gerät verstanden werden, wie sie insbesondere für die Automatisierung von Behandlungsanlagen zum Einsatz kommen. Dies sind insbesondere Sensoren, Aktoren und/oder Sende- und Empfangseinheiten für Daten oder sonstige physikalische Größen.

Alle Aspekte, Vorteile und Merkmale der Lagerungseinheit und/oder des Endgerätes allein sollen identisch oder in analoger Weise auch für die Kombination aus Lagerungseinheit mit dem Endgerät gelten, wenn nicht ausdrücklich etwas Unterschiedliches ausgeführt wird. Ebenso sollen alle Aspekte, Vorteile und Merkmale des Endgerätes, die im Zusammenhang mit der Lagerungseinheit genannt wurden auch für die Kombination aus Lagerungseinheit mit dem Endgerät und/oder für ein Endgerät, welches eine Lagerungseinheit umfasst, gelten - und umgekehrt.

Es sei auch noch darauf hingewiesen, dass im Rahmen der hier vorliegenden Patentanmeldung unbestimmte Artikel und unbestimmte Zahlenangaben wie "ein...", "zwei..." usw. im Regelfall als mindestens-Angaben zu verstehen sein sollen, also als "mindestens ein... ", "mindestens zwei..." usw., sofern sich nicht etwa aus dem Kontext oder dem konkreten Text einer bestimmten Stelle ergibt, dass etwa dort nur "genau ein...", "genau zwei..." usw. gemeint sein soll.

An dieser Stelle sei noch erwähnt, dass im Rahmen der hier vorliegenden Patentanmeldung der Ausdruck "insbesondere" immer so zu verstehen ist, dass mit diesem Ausdruck ein optionales, bevorzugtes Merkmal eingeleitet wird. Der Ausdruck ist nicht als "und zwar" und nicht als "nämlich" zu verstehen.

Der große Vorteil diese Lösung besteht darin, dass eine intuitive Bedienung zur werkzeugfreien Änderung der Position und Ausrichtung der (aktiven) Stirnseite des Endgerätes möglich ist. Mittels weniger mechanischer Teile kann eine sehr große Flexibilität erreicht werden. Zudem sind keine separate Halterung, Lagerplatten oder sonstigen losen Teile erforderlich.

Vorzugsweise sind einzelne Bestandteile des als "einstückig" beschriebenen Elements stoffschlüssig miteinander verbunden.

Weitere Einzelheiten und Vorteile der Erfindung sollen nun anhand eines in den Zeichnungen dargestellten Ausführungsbeispiels näher erläutert werden.

Es zeigen:
- Fig. 1: eine Ausführungsform als Draufsicht auf die Lagerungseinheit und des elektronischen Endgerätes in der Verriegelungsposition,
- Fig. 2: die Ausführungsform nach Figur 1 als Draufsicht in der Entriegelungsposition,
- Fig. 3: eine zu Figur 1 vergleichbare Ausführungsform als Draufsicht auf die Anschlussseite und
- Fig. 4: eine zur Figur 3 alternative Ausführungsform in zwei Teilansichten, wobei eine der Teilansichten eine Schnittdarstellung ist.

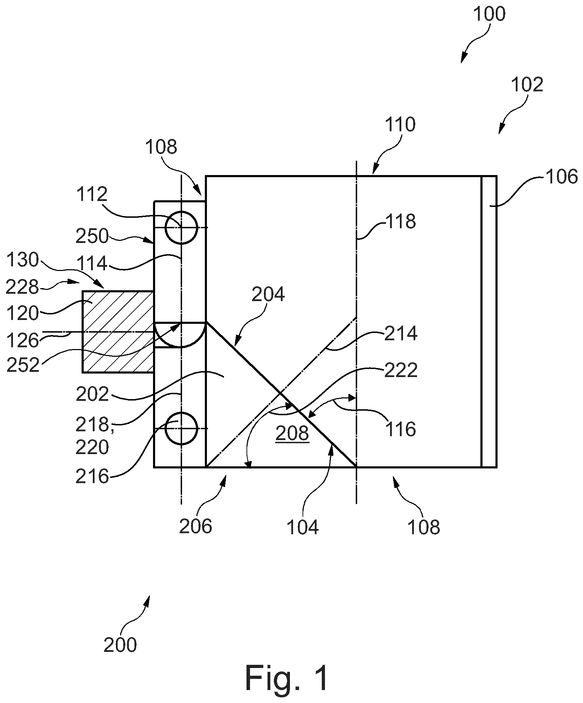

Fig. 1 zeigt einen schematischen Aufbau einer Lagerungseinheit 200 für ein elektronisches Endgerät 100, der vorliegend ein induktiver Näherungssensor ist. Dieser umfasst
- einen Lagerungskörper 202 mit einer Auflagefläche 204 für das elektronische Endgerät 100, drei Anlageflächen 206, 208 und eine Anschlussseite 228, wobei die Anlagefläche 208 in der Bildebene dargestellt ist und analog auf der Rückseite vorhanden ist. In der gezeigten Draufsicht ist der Lagerungskörper 202 als Dreieck dargestellt und die dargestellte Unterseite ist die erste mögliche Anlagefläche 206 und die beiden hierzu vertikal stehenden, näherungsweise dreieckigen Seitenflächen sind die weiteren Anlageflächen 208, wovon nur die in der Darstellung vordere Anlagefläche 208 zu sehen ist.

Bei dem Ausführungsbeispiel ist insbesondere die Auflagefläche 204 als ebene Fläche ausgebildet.

Ferner ist bei dem Beispiel mindestens eine Anlagefläche 206, 208 als ebene Fläche ausgebildet. Insbesondere können alle drei Anlageflächen 206, 208 als ebene Flächen ausgebildet sein.

Weiterhin sind im Lagerungskörper 202 drei Befestigungselemente 216, 218, 220 zur Anbringung der Lagerungseinheit 200 an einem Tragelement vorgesehen, wobei für das Befestigungselement 218 nur die Lage der Achse der Durchgangsbohrung dargestellt ist, die das Befestigungselement 218 darstellt. Das Befestigungselement 220 ist hierzu parallel ausgerichtet, so dass sich in der Draufsicht die beiden Achsen überdecken.

In einem nicht dargestellten Ausführungsbeispiel ist zur vibrationsfreien Anbringung auf einer Teilstrecke in einem als Durchgangsbohrung ausgebildeten Befestigungselement 216, 218, 220 ein (Mutter-)Innengewinde angebracht.

Der Lagerungskörper 202 weist eine schräge Auflagefläche 204 auf, der mit der unteren Anlagefläche 206 und der hinteren Anschlussseite 228 einen Neigungswinkel 222 von jeweils 45° einschließt.

Das elektronische Endgerät 100 ist in einem nicht dargestellten Gleitlager rotierbar auf der Auflagefläche 204 angeordnet und kann um eine Drehachse 214 verdreht werden. Erfindungsgemäß verläuft die Drehachse 214 senkrecht zur Auflagefläche.

Das Endgerät 100 weist ein Gehäuse 102 auf, mit einer Fußfläche 104, einer Stirnseite 106, einem Seitenteil 110 und vier Rückseiten 108. Hierbei sind die Rückseiten 108 dadurch bestimmt, dass diese durch eine Verdrehung des Gehäuses 102 um die Drehachse 214 in eine rückseitige Position verbringbar sind, also durch Verdrehung einen Teil der hinteren Anschlussseite 228 bilden können.

Das in der Darstellung der Figur 1 obere Seitenteil 110 kann nicht in eine solche rückseitige Position gebracht werden.

Die eigentlichen elektronischen Bauteile und Komponenten des Endgerätes 100 sind nicht dargestellt. Die Stirnseite 106 weist in der Darstellung der Figur 1 nach rechts und steht der Anschlussseite 228 des Lagerungskörpers 202 bzw. der Lagerungseinheit 200 gegenüber.

Das Gehäuse 102 hat im Wesentlichen eine Würfelform mit den Abmessungen von 40x40x40 mm Kantenlänge. Die vorgenannte Kantenlänge ist sehr vorteilhaft in der Automatisierungstechnik, wobei die Kantenlängen hierauf nicht beschränkt sind und beispielsweise im Bereich von 10x10x10 mm bis 100x100x100 mm liegen können.

Die Stirnseite 106 ist die Funktions- oder Erfassungsfläche des Sensors, deren Ausrichtung für die gewünschte Funktion entscheidend ist.

Die Lagerungseinheit 200 weist ein verschwenkbares Riegelelement 250 auf, das an einer senkrecht zur Bildebene stehenden Schwenkachse 252 schwenkbar gelagert ist. Das Riegelelement 250 ist in seiner Verriegelungsposition dargestellt, indem es an einer Rückseite 108 des Endgerätes 100 bzw. dessen Gehäuses 102 anliegt. Hierdurch wird das elektronisches Endgerät 100 in seiner Drehposition verriegelt.

Das Riegelelement 250 weist drei Befestigungselemente 112, 114 auf, von denen ein Befestigungselement 112 in Richtung auf die Bildebene verläuft und als Öffnung im Riegelelement 250 dargestellt ist. Die beiden anderen Befestigungselemente 114 stehen hierzu im Winkel von 90° quer oder senkrecht und sind als eine strichpunktierte Linie dargestellt. In dem gezeigten Beispiel sind die Befestigungselemente 112, 114 als Durchgangsbohrungen ausgebildet. In einem nicht dargestellten Ausführungsbeispiel ist zur vibrationsfreien Anbringung auf einer Teilstrecke in mindestens einem als Durchgangsbohrung ausgebildeten Befestigungselement 112, 114 ein (Mutter-)Innengewinde angebracht.

In analoger Weise ist die Fußfläche 104 des Endgerätes 100 gegenüber einer zur Stirnseite 106 parallelen Ebene 118 ebenfalls um 90° minus dem Neigungswinkel 222 der Auflagefläche 204 geneigt, also ist die Fußfläche 104 ebenfalls um einen Neigungswinkel 116 von 45° gegenüber der Ebene 118 geneigt.

Wie in der Figur 1 ersichtlich, wird das Riegelelement 250 in der Verriegelungsposition festgelegt, wenn durch das Befestigungselement 112 oder durch mindestens eines der hierzu senkrecht verlaufenden Befestigungselemente 114 ein Befestigungsmittel wie eine Schraube geführt wird. Hierbei setzt sich das Befestigungselement 114 in dem Lagerungskörper 202 und einem dortigen Befestigungselement 218 fort, so dass die beiden Befestigungsmittel 114, 218 ein gemeinsames Befestigungsmittel bilden, die im Befestigungsfall von einem gemeinsamen Befestigungsmittel durchdrungen werden. Sinnvolle Dämpfungsmittel, zur Verhinderung von Vibrationen und Beschädigungen des elektronischen Endgerätes 100, wie elastische Unterlegscheiben oder Anlagematten, sind nicht dargestellt.

Weiterhin ist ein Steckverbinder 120 vorgesehen, dessen Steckerachse 126 senkrecht zur Anschlussseite 228 ausgerichtet ist und der auf der Außenseite ein Gebinde 130 für eine Überwurfmutter für einen nicht dargestellten Gegensteckverbinder aufweist.

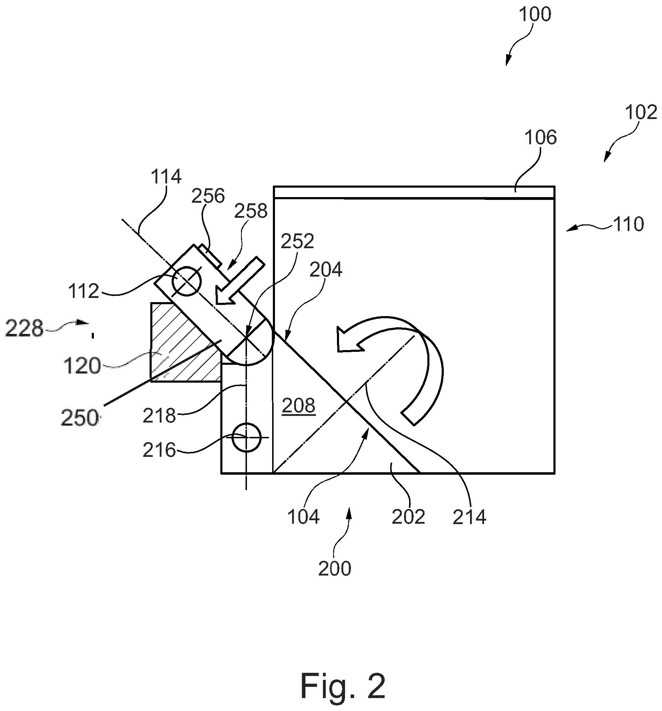

Die Ausführungsform nach Figur 2 entspricht der Ausführungsform nach Figur 1, wobei das Riegelelement 250 in die Entriegelungsposition verbracht ist, in der das Endgerät 100 um die Drehachse 214 gedreht werden kann.

Bei der gezeigten Ausführungsform liegt das Riegelelement 250 in der entsperrten Stellung auf dem Steckverbinder 120 auf und das Gehäuse 102 kann um die Achse 214 gedreht werden. Um von der Lage der Stirnseite 106 des Endgerätes 100 gemäß der Figur 1 zu der Lage der Stirnseite 106 gem. der Figur 2 zu gelangen, wurde die das Endgerät 100 bzw. dessen Gehäuse 102 um 180° um die Achse 214 gedreht. Somit weist die Stirnseite 106 in der Darstellung nach der Drehung nach oben und grenzt an die Anschlussseite 228 des Lagerungskörpers 202 an.

Wie in der Figur 1 und in der Figur 2 zu erkennen, weist das Riegelelement 250 an der Lagerseite einen Radius auf, der in einer entsprechenden Gegenkontur im Lagerungskörper geführt ist. In der Entriegelungsposition oder einer Übergangsstellung spannen die Innenseite 258 des Riegelelements 250 und die Auflagefläche 204 eine gemeinsame Fläche auf. Alternativ bildet die Innenseite 258 in der Entriegelungsposition oder in einer Übergangsstellung eine parallele, rückspringende Ebene auf, so dass das Endgerät störungsfrei um die Drehachse 214 gedreht werden kann.

Auf der Innenseite 258 des Riegelelements 250 ist ein Dämpfungselement 256 in Form eines elastischen Formkörpers aufgeklebt, der eine Vibrationsdämpfung zwischen dem Gehäuse 102 des Endgerätes 100 und dem Riegelelement 250 ermöglicht.

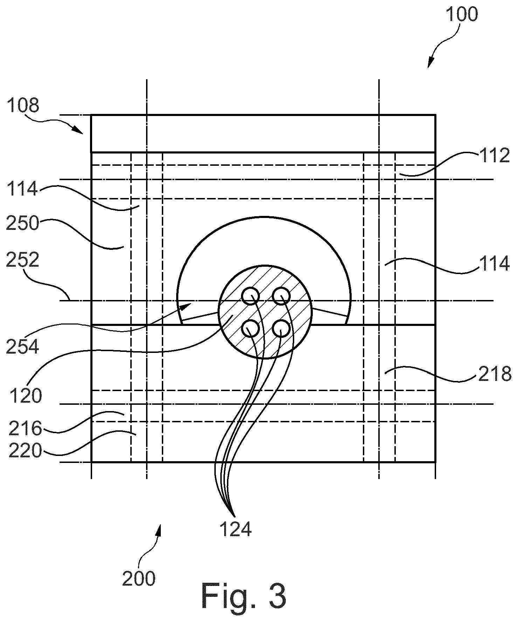

Bei dem Ausführungsbeispiel nach Figur 3 ist das Endgerät 100 mit der Lagerungseinheit 200 aus der Blickrichtung auf die Anschlussseite 228 gezeigt, wobei sich das Riegelelement 250 in der Verriegelungsposition befindet.

Erkennbar sind die parallel zur Schwenkachse 252 ausgerichteten Befestigungselemente 112, 216 und die sich in der Verriegelungsposition ergänzenden Paare aus den Befestigungselementen 114, 218 sowie den Befestigungselementen 114, 220.

Das Riegelelement 250 weist in dem Ausführungsbeispiel eine Durchführungsöffnung 254 auf, die einen Zugang zu einem Steckverbinder im Lagerungskörper 202 und damit zum Endgerät 100 ermöglicht. Die Durchführungsöffnung 254 ist konisch aufgeweitet. Die Durchführungsöffnung 254 ist im Übergang vom Lagerungskörper 202 und dem Riegelelement 250, so dass auch im Lagerungskörper 202 ein Teil der Öffnung vorgesehen ist, die zusammen mit dem Öffnungsteil im Riegelelement 250 eine kreisrunde Durchführungsöffnung 254 bilden.

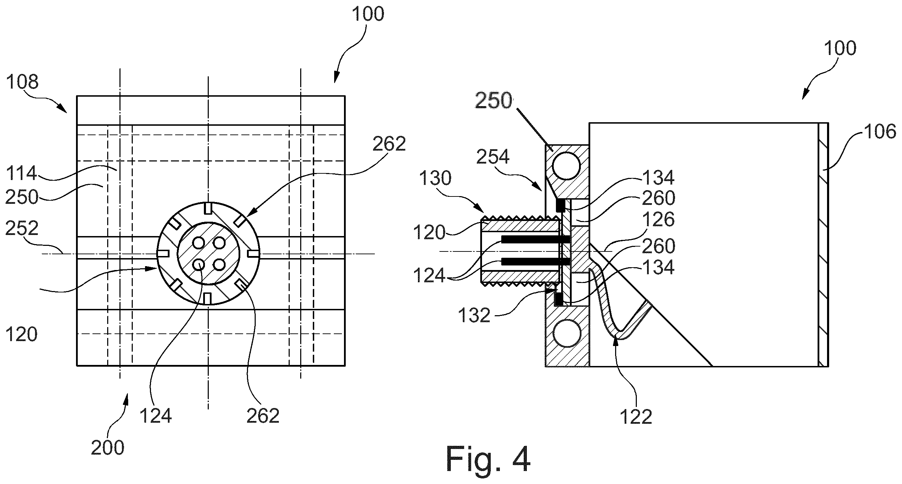

Im Ausführungsbeispiel der Figur 4 ist analog zur Figur 3 eine Durchführungsöffnung 254 im Riegelelement 250 vorgesehen, wobei bezüglich der sonstigen Bezugszeichen und Beschreibungen auf die Figur 3 verwiesen wird. Im Unterschied zur Ausführungsform gemäß der Figur 3 ist ein loser Steckverbinder 120 vorgesehen, dessen vier Kontaktstifte 124 von dem Gewinde 130 umschlossen werden und nach außen weisen. Die rechte Teildarstellung ist eine Schnittdarstellung, wobei die Steckerachse 126 in der Schnittebene liegt.

Wie insbesondere in der rechten Teildarstellung verdeutlicht, weist der Steckverbinder 120 einen Flansch 132 mit mehreren Rastelementen 134 auf. Diese Rastelemente 134 können von korrelierenden Rastöffnungen 262 aufgenommen werden, die auf der Innenseite des Riegelelements 250 bzw. im Bereich einer Aussparung 260 auf der Innenseite 258 des Riegelelements 250 und im Lagerungskörper 202 angeordnet sind. Auf diese Weise kann die Drehlage des Steckverbinders 120 festgelegt werden und ein schädigendes Tordieren der Leitung 122 verhindert werden.

Die Rastöffnungen 262 sind, wie in der linken Teildarstellung gezeigt, als durchgängige Öffnung ausgeführt, so dass ein Benutzer diese optisch auf der Anschlussseite 228 schnell erfassen kann. Vorteilhafterweise kann über die Rastelemente 134 und die korrelierenden Rastöffnungen 132 eine eindeutige Zwangslage des Steckverbinders 120 in einer Drehlage um die Steckerachse 126 oder einer definierten Anzahl von Drehlagen um die Steckerachse 126 erreicht werden.

Wie weiterhin in der rechten Teildarstellung zu erkennen, schlägt der Steckverbinder 120 mit seinem hinteren Ende an die Rückseite 108 des Endgerätes 100 bzw. dessen Gehäuses 102 an, wobei der Steckverbinder 120 und der Flansch 132 in der Aussparung 260 etwas Spiel haben, wobei geeignete Dämpfungselemente vorgesehen sein können, um eine Einklemmen des Flansches 132 zu erreichen (nicht dargestellt).

Im Inneren des Lagerungsköpers 202 ist eine Leitung 122 mit mehreren Adern vom Steckverbinder 120 zum Innenraum des Gehäuses 102 vorgesehen, über die das Endgerät 100 daten- und/oder stromleitend versorgt ist.

### Bezugszeichenliste

- 100: Endgerät, elektronisches
- 102: Gehäuse
- 104: Fußfläche
- 106: Stirnseite
- 108: Rückseite

- 110: Seitenteil
- 112: Befestigungselement
- 114: Befestigungselement
- 116: Neigungswinkel
- 118: Ebene

- 120: Steckverbinder
- 122: Leitung
- 124: Kontaktstifte
- 126: Steckerachse

- 130: Gewinde für Gegensteckverbinder
- 132: Flansch
- 134: Rastelement

- 200: Lagerungseinheit
- 202: Lagerungskörper
- 204: Auflagefläche
- 206: Anlagefläche
- 208: Anlagefläche

- 214: Drehachse
- 216: Befestigungselement
- 218: Befestigungselement
- 220: Befestigungselement
- 222: Neigungswinkel der Auflagefläche

- 228: Anschlussseite

- 250: Riegelelement
- 252: Schwenkachse
- 254: Durchführungsöffnung
- 256: Dämpfungselement
- 258: Innenseite
- 260: Aussparung
- 262: Rastöffnung

## Patentansprüche

1. Lagerungseinheit (200) für ein elektronisches Endgerät (100), umfassend
- einen Lagerungskörper (202) mit einer Auflagefläche (204) für das elektronische Endgerät (100) und mindestens eine Anlagefläche (206, 208) zur Anlage mindestens einer der Anlageflächen (206, 208) an einem Tragelement,
- mindestens ein Befestigungselement (112, 114, 216, 218, 220) zur Anbringung der Lagerungseinheit (200) an einem Tragelement, wobei die Auflagefläche (204) zur mindestens einen Anlagefläche (206, 208) einen Neigungswinkel einschließt, insbesondere einen Neigungswinkel von 45° einschließt, und wobei das elektronische Endgerät (100) auf der Auflagefläche (204) um eine Drehachse (214), die senkrecht zur Auflagefläche (204) verläuft, verdrehbar angeordnet ist, wobei die Lagereinheit (200) mindestens ein verschwenkbares Riegelelement (250) aufweist, mittels welchem das elektronische Endgerät (100) in seiner Lage verriegelbar ist.

2. Vorrichtung nach Anspruch 1, **dadurch gekennzeichnet, dass** das Riegelelement (250) um mindestens eine Schwenkachse (252) verschwenkbar ist, die parallel zur Auflagefläche (204) und mindestens einer Anlagefläche (206, 208) ausgerichtet ist.

3. Vorrichtung nach Anspruch 1 oder 2, **dadurch gekennzeichnet, dass** das Riegelelement (250) ein weiteres Befestigungselement (112, 114) umfasst.

4. Vorrichtung nach Anspruch 3, **dadurch gekennzeichnet, dass** das Riegelelement (250) mindestens zwei Befestigungselemente (112, 114) umfasst, die senkrecht zueinander ausgerichtet sind.

5. Vorrichtung nach einem der Ansprüche 3 oder 4, **dadurch gekennzeichnet, dass** mindestens ein Befestigungselement (112, 114) eine Durchgangsbohrung ist.

6. Vorrichtung nach Anspruche 5, **dadurch gekennzeichnet, dass** mindestens eines der als Durchgangsbohrung ausgeführten Befestigungselemente (112, 114) in einer Endposition des Riegelelementes (250) mit einer gemeinsamen Bohrachse durch das Riegelelement (250) und das Befestigungselement (204) geführt ist.

7. Vorrichtung nach einer der vorherigen Ansprüche, **dadurch gekennzeichnet, dass** das Befestigungselement (204) mindestens einen Lagerabschnitt aufweist, an dem das elektronische Endgerät (100) im angeordneten Zustand rotierbar gelagert ist, insbesondere mittels eines komplementären Gegenlagerabschnitt rotierbar gelagert ist.

8. Vorrichtung nach einer der vorherigen Ansprüche, **dadurch gekennzeichnet, dass** das Riegelelement (250) mindestens aus zwei Teilelementen besteht, wobei die Teilelemente um dieselbe Schwenkachse (252) oder jeweils um eine von zwei zueinander parallelen Schwenkachsen (252) verschwenkbar sind.

9. Vorrichtung nach einer der vorherigen Ansprüche, **dadurch gekennzeichnet, dass** das Riegelelement (250) und/oder der Lagerungskörper (202) eine Durchführungsöffnung (254) aufweist, insbesondere das Riegelelement (250) und/oder der Lagerungskörper (202) jeweils einen Teil einer Öffnung aufweisen, die gemeinsam eine Durchführungsöffnung (254) bilden.

10. Vorrichtung nach Anspruch 9, **dadurch gekennzeichnet, dass** das Riegelelement (250) auf der zur Auflagefläche (204) zugewandten Seite eine Aussparung (260) zur form- und/oder kraftschlüssigen Aufnahme mindestens einer Teilkontur eines Steckverbinders (120) aufweist.

11. Vorrichtung nach einer der vorherigen Ansprüche, **dadurch gekennzeichnet, dass** das Riegelelement (250) um eine Schwenkachse (252) verschwenkbar und quer zur Schwenkachse (252) heb- und absenkbar ist, insb. in der verriegelnden Position heb- und absenkbar ist.

12. Elektrisches Endgerät (100) mit einer Lagerungseinheit (200), das elektrische Endgerät (100) umfassend ein Gehäuse (102) mit mehreren Seiten, wobei eine Seite eine Stirnseite (106) ist, welche als Erfassungs- und/oder Funktionsseite ausgebildet ist, wobei die Lagerungseinheit (200) eine Lagerungseinheit (200) nach einem der vorherigen Ansprüche ist und am Gehäuse (102) angebracht ist.

13. Endgerät (100) nach Anspruch 12, **dadurch gekennzeichnet, dass** das Endgerät ein Sensor oder eine Datenerfassungsgerät ist.

## Claims

1. Mounting unit (200) for an electronic terminal (100), comprising
- a mounting body (202) with a support surface (204) for the electronic terminal (100) and at least one contact surface (206, 208) for at least one of the contact surfaces (206, 208) to bear against a supporting element,
- at least one fastening element (112, 114, 216, 218, 220) for attaching the mounting unit (200) to a supporting element, wherein the support surface (204) encloses an angle of inclination, in particular an angle of inclination of 45°, with at least one contact surface (206, 208) and wherein the electronic terminal (100) is arranged on the support surface (204) rotatably about a rotation axis (214), which runs perpendicular to the support surface (204), wherein the bearing unit (200) has at least one pivotable bolt element (250), by means of which the electronic terminal (100) can be locked in its position.

2. Device according to Claim 1, **characterized in that** the bolt element (250) can be pivoted about at least one pivot axis (252), which is oriented parallel to the support surface (204) and at least one contact surface (206, 208).

3. Device according to Claim 1 or 2, **characterized in that** the bolt element (250) comprises a further fastening element (112, 114).

4. Device according to Claim 3, **characterized in that** the bolt element (250) comprises at least two fastening elements (112, 114), which are oriented perpendicularly with respect to each other.

5. Device according to either of Claims 3 and 4, **characterized in that** at least one fastening element (112, 114) is a through-bore.

6. Device according to Claim 5, **characterized in that** at least one of the fastening elements (112, 114) embodied as a through-bore is guided through the bolt element (250) and the fastening element (204) in an end position of the bolt element (250) with a common bore axis.

7. Device according to any of the preceding claims, **characterized in that** the fastening element (204) has at least one bearing portion, on which the electronic terminal (100) is rotatably mounted in the arranged state, in particular is rotatably mounted by means of a complementary counter-bearing portion.

8. Device according to any of the preceding claims, **characterized in that** the bolt element (250) consists of at least two part-elements, wherein the part-elements can be pivoted about the same pivot axis (252) or can each be pivoted about one of two mutually parallel pivot axes (252).

9. Device according to any of the preceding claims, **characterized in that** the bolt element (250) and/or the mounting body (202) has a lead-through opening (254), in particular the bolt element (250) and/or the mounting body (202) each have a portion of an opening, which portions together form a lead-through opening (254).

10. Device according to Claim 9, **characterized in that** the bolt element (250) has, on the side facing the support surface (204), a cutout (260) for positively and/or non-positively receiving at least one part-contour of a plug-in connector (120).

11. Device according to any of the preceding claims, **characterized in that** the bolt element (250) can be pivoted about a pivot axis (252) and can be lifted and lowered transversely to the pivot axis (252), in particular can be lifted and lowered in the locking position.

12. Electrical terminal (100) having a mounting unit (200), the electrical terminal (100) comprising a housing (102) having several sides, wherein one side is a front side (106), which is designed as a detection and/or functional side, wherein the mounting unit (200) is a mounting unit (200) according to any of the preceding claims and is attached to the housing (102).

13. Terminal (100) according to Claim 12, **characterized in that** the terminal is a sensor or a data acquisition device.

## Revendications

1. Unité de support (200) pour un terminal électronique (100), comprenant
- un corps (202) de support ayant une surface d'appui (204) pour le terminal électronique (100) et au moins une surface de contact (206, 208) pour le contact d'au moins une des surfaces de contact (206, 208) avec un élément porteur,
- au moins un élément de fixation (112, 114, 216, 218, 220) pour fixer l'unité de support (200) à un élément porteur, la surface d'appui (204) formant un angle d'inclinaison avec au moins une surface de contact (206, 208), en particulier un angle d'inclinaison de 45°, et le terminal électronique (100) étant disposé sur la surface d'appui (204) de manière à être apte à tourner autour d'un axe de rotation (214) qui s'étend perpendiculairement à la surface d'appui (204), l'unité de support (200) présentant au moins un élément de verrouillage pivotant (250) au moyen duquel le terminal électronique (100) est apte à être verrouillé dans sa position.

2. Dispositif selon la revendication 1, **caractérisé en ce que** l'élément de verrouillage (250) est apte à pivoter autour d'au moins un axe de pivotement (252) qui est parallèle à la surface d'appui (204) et à au moins une surface de contact (206, 208).

3. Dispositif selon la revendication 1 ou la revendication 2, **caractérisé en ce que** l'élément de verrouillage (250) comprend un élément de fixation supplémentaire (112, 114).

4. Dispositif selon la revendication 3, **caractérisé en ce que** l'élément de verrouillage (250) comprend au moins deux éléments de fixation (112, 114) qui sont orientés perpendiculairement l'un à l'autre.

5. Dispositif selon l'une des revendications 3 ou 4, **caractérisé en ce qu'**au moins un élément de fixation (112, 114) est un alésage traversant.

6. Dispositif selon la revendication 5, **caractérisé en ce qu'**au moins l'un des éléments de fixation (112, 114) réalisés sous forme de trou traversant est guidé dans une position finale de l'élément de verrouillage (250) avec un axe de perçage commun à travers l'élément de verrouillage (250) et l'élément de fixation (204).

7. Dispositif selon l'une des revendications précédentes, **caractérisé en ce que** l'élément de fixation (204) présente au moins une partie de support sur laquelle le terminal électronique (100) est monté de manière rotative à l'état monté, en particulier au moyen d'une partie de support complémentaire.

8. Dispositif selon l'une des revendications précédentes, **caractérisé en ce que** l'élément de verrouillage (250) est constitué d'au moins deux éléments partiels, les éléments partiels étant aptes à pivoter autour du même axe de pivotement (252) ou autour d'un axe parmi deux axes de pivotement (252) parallèles entre eux.

9. Dispositif selon l'une des revendications précédentes, **caractérisé en ce que** l'élément de verrouillage (250) et/ou le corps de support (202) présente une ouverture de passage (254), en particulier l'élément de verrouillage (250) et/ou le corps de support (202) présente(nt) respectivement une partie d'une ouverture qui forment ensemble une ouverture de passage (254).

10. Dispositif selon la revendication 9, **caractérisé en ce que** l'élément de verrouillage (250) présente, sur le côté tourné vers la surface d'appui (204), un évidement (260) destiné à recevoir par complémentarité de forme et/ou par adhérence au moins un contour partiel d'un connecteur (120).

11. Dispositif selon l'une des revendications précédentes, **caractérisé en ce que** l'élément de verrouillage (250) est apte à pivoter autour d'un axe de pivotement (252) et est apte à être levé et abaissé transversalement à l'axe de pivotement (252), en particulier est apte à être levé et abaissé dans la position de verrouillage.

12. Terminal électrique (100) ayant une unité de support (200), le terminal électrique (100) comprenant un boîtier (102) avec plusieurs côtés, un côté étant une face frontale (106) qui est conçue comme côté de détection et/ou côté fonctionnel, l'unité de support (200) étant une unité de support (200) selon l'une des revendications précédentes et étant fixée au boîtier (102).

13. Terminal (100) selon la revendication 12, **caractérisé en ce que** le terminal est un capteur ou un appareil d'acquisition de données.
